(19) Europäisches Patentamt
European Patent Office
Office européen des brevets

(11) **EP 4 006 958 A1**

(12) **DEMANDE DE BREVET EUROPEEN**

(43) Date de publication:
**01.06.2022 Bulletin 2022/22**

(21) Numéro de dépôt: **21209321.5**

(22) Date de dépôt: **19.11.2021**

(51) Classification Internationale des Brevets (IPC):
**H01L 21/56** (2006.01)    **H01L 21/3105** (2006.01)
**H01L 21/311** (2006.01)    **H01L 21/321** (2006.01)
**H01L 23/31** (2006.01)    **H01L 21/768** (2006.01)

(52) Classification Coopérative des Brevets (CPC):
**H01L 23/3121; H01L 21/31053; H01L 21/31056;
H01L 21/56; H01L 21/76829; H01L 23/3135;
H01L 24/10**

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**
Etats de validation désignés:
**KH MA MD TN**

(30) Priorité: **27.11.2020 FR 2012266**

(71) Demandeurs:
- **Commissariat à l'énergie atomique
et aux énergies alternatives
75015 Paris (FR)**

- **Weebit Nano Ltd
4527713 Hod-HaSharon (IL)**

(72) Inventeurs:
- **NODIN, Jean-François
38054 Grenoble Cedex 09 (FR)**
- **MOLAS, Gabriel
38054 Grenoble Cedex 09 (FR)**
- **COHEN, Yifat
Kiryat Tivon (IL)**
- **REGEV, Amir
Modiin (IL)**

(74) Mandataire: **INNOV-GROUP
310, avenue Berthelot
69372 Lyon Cedex 08 (FR)**

(54) **PROCÉDÉ DE REPRISE DE CONTACT ÉLECTRIQUE**

(57)    Procédé de reprise de contact électrique, comportant les étapes :

a) prévoir des puces (P) électroniques, surmontées de plots (1) de contact électrique, et formées sur un substrat (2) ; les plots (1) et le substrat (2) étant revêtus d'une couche de passivation (3) ;

b) former un empilement sur la couche de passivation (3), comportant :

- une première couche d'aplanissement (4), réalisée dans un premier matériau autorisant une gravure chimique sélective par rapport à la couche de passivation (3), et formée sur la couche de passivation (3) de manière à affleurer le sommet des plots (1) ;

- une deuxième couche d'aplanissement (5), réalisée dans un deuxième matériau ;

- une couche intercalaire (CI), réalisée dans un matériau autorisant une gravure chimique sélective du deuxième matériau ;

c) polir l'empilement, par un polissage mécano-chimique, jusqu'à atteindre la couche de passivation (3) revêtant les plots (1) ;

d) graver la couche de passivation (3) revêtant les plots (1) de manière à mettre à nu le sommet des plots (1).

Fig. 1

## Description

## Domaine technique

L'invention se rapporte au domaine technique de la fabrication de puces électroniques nécessitant une reprise de contact sur des plots de contact électriques.

L'invention trouve notamment son application dans la fabrication de puces électroniques de type puce de mémoire résistive (RRAM pour « *Resistive Random-Access Memory* » en langue anglaise), en particulier de type à accès aléatoire à base de lacunes d'oxygène (OxRAM pour « *Oxide-based Random-Access Memory* » en langue anglaise).

## État de l'art

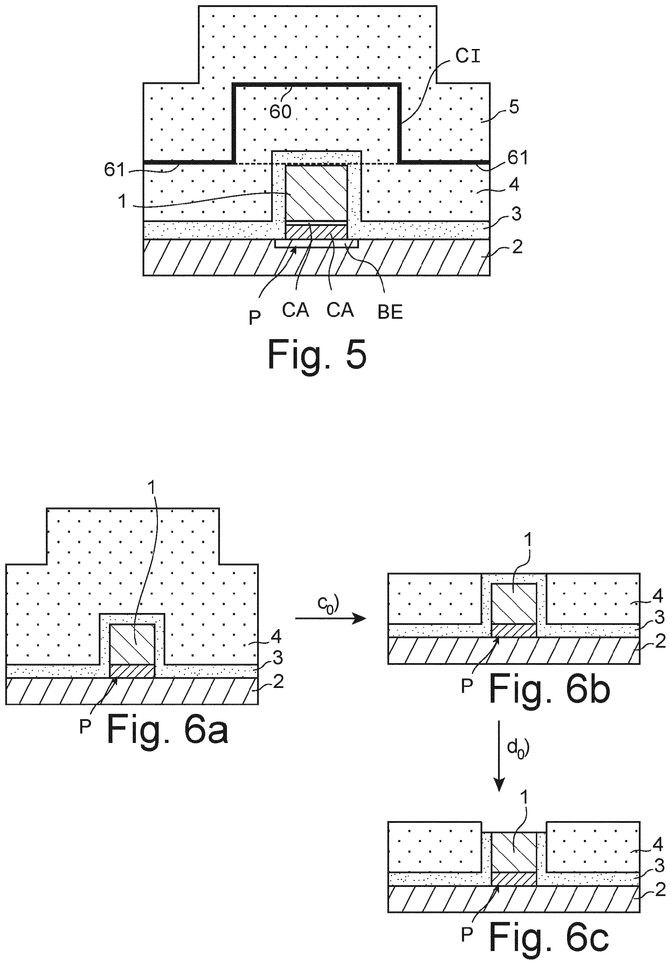

Comme illustré aux figures 6a à 6c, un procédé de reprise de contact électrique connu de l'état de la technique, comporte les étapes :

$a_0$) prévoir des puces P électroniques, surmontées de plots 1 de contact électrique, et formées sur un substrat 2 ; les plots 1 de contact électrique et le substrat 2 étant revêtus d'une couche de passivation 3 ;

$b_0$) former une couche d'aplanissement 4 sur la couche de passivation ; la couche d'aplanissement 4 étant réalisée dans un matériau autorisant une gravure chimique sélective par rapport à la couche de passivation 3 ;

$c_0$) polir la couche d'aplanissement 4, par un polissage mécano-chimique, jusqu'à atteindre la couche de passivation 3 revêtant les plots 1 de contact électrique ; le polissage mécano-chimique utilisant une gravure chimique sélective entre le matériau de la couche d'aplanissement 4 et la couche de passivation 3 ;

$d_0$) graver la couche de passivation 3 revêtant les plots 1 de contact électrique de manière à mettre à nu le sommet des plots 1 de contact électrique.

Un tel procédé de l'état de la technique n'est pas entièrement satisfaisant dans la mesure où le polissage mécano-chimique de la couche d'aplanissement, exécuté lors de l'étape $c_0$), est inhomogène (non-uniforme) selon la position et la densité des puces électroniques sur le substrat. Le polissage mécano-chimique de la couche d'aplanissement varie également en fonction de l'état d'usure des consommables tels que la solution de polissage (« *slurry* » en langue anglaise, dénommée également bouillie de polissage), ou les tampons de polissage « *pads* » en langue anglaise, dénommés également tissus de polissage).

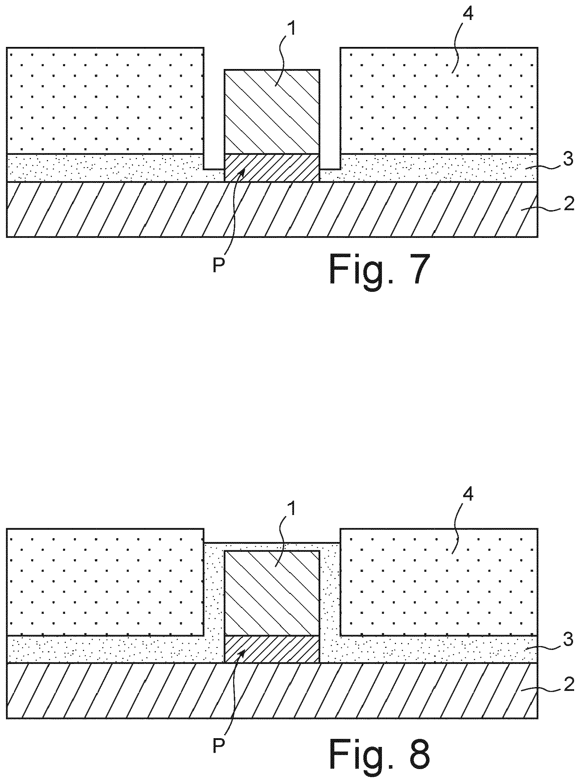

D'une part, la couche d'aplanissement est susceptible d'être surgravée -au sens d'un sur-polissage- au centre du substrat (comme illustré à la figure 7), pouvant occasionner des courts-circuits, tandis que la couche d'aplanissement est susceptible d'être insuffisamment polie en bordure de substrat (comme illustré à la figure 8), pouvant occasionner des circuits ouverts.

D'autre part, la couche d'aplanissement est susceptible d'être surgravée -au sens d'un sur-polissage- dans les régions du substrat à faible densité de puces électroniques (phénomène de « *dishing* » en langue anglaise), pouvant occasionner des courts-circuits.

## Exposé de l'invention

L'invention vise à remédier en tout ou partie aux inconvénients précités. A cet effet, l'invention a pour objet un procédé de reprise de contact électrique, comportant les étapes :

a) prévoir des puces électroniques, surmontées de plots de contact électrique, et formées sur un substrat ; les plots de contact électrique et le substrat étant revêtus d'une couche de passivation ;

b) former un empilement de couches d'aplanissement sur la couche de passivation, l'empilement comportant :

- une première couche d'aplanissement, réalisée dans un premier matériau autorisant une gravure chimique sélective par rapport à la couche de passivation, et formée sur la couche de passivation de manière à affleurer le sommet des plots de contact électrique ;
- une deuxième couche d'aplanissement, réalisée dans un deuxième matériau ;
- une couche intercalaire, intercalée entre les première et deuxième couches d'aplanissement, et réalisée dans un matériau autorisant une gravure chimique sélective du deuxième matériau ;

c) polir l'empilement, par un polissage mécano-chimique, jusqu'à atteindre la couche de passivation revêtant les plots de contact électrique ; le polissage mécano-chimique utilisant une gravure chimique sélective entre le deuxième matériau et le matériau de la couche intercalaire ;

d) graver la couche de passivation revêtant les plots de contact électrique de manière à mettre à nu le sommet des plots de contact électrique.

Autrement dit, l'étape b) consiste à former un empilement de couches d'aplanissement sur la couche de passivation, l'empilement comportant successivement :

- une première couche d'aplanissement, réalisée dans un premier matériau autorisant une gravure chimique sélective par rapport à la couche de passivation, et formée sur la couche de passivation de manière à affleurer les sommets des plots de contact électrique ;

- une couche intercalaire ;
- une deuxième couche d'aplanissement, réalisée dans un deuxième matériau ;

la couche intercalaire, intercalée entre les première et deuxième couches d'aplanissement, est réalisée dans un matériau autorisant une gravure chimique sélective du deuxième matériau par rapport à la couche intercalaire.

Autrement dit, l'étape d) consiste à graver la couche de passivation revêtant les plots de contact électrique de manière à mettre à nu les sommets des plots de contact électrique.

## Définitions

- Par « puce électronique » (« *die* » ou « *chip* » en langue anglaise), on entend une partie d'un substrat ayant subie des étapes technologiques en vue de former un composant électronique (destiné à être monté sur une carte électronique ou dans un boîtier).
- Par « substrat », on entend un support physique autoporté, pouvant être par exemple une plaquette (« *wafer*» en langue anglaise) découpée dans un lingot monocristallin de matériau semi-conducteur.
- Par « couche de passivation », on entend une couche adaptée pour la neutralisation de défauts électriquement actifs à la surface du substrat. En effet, la surface d'un substrat (e.g. en silicium cristallin) présente une densité de défauts tels que des liaisons pendantes, des impuretés, des discontinuités de cristal etc.
- Par « couche d'aplanissement» *(«planarization layer»* en langue anglaise), on entend une couche destinée à modifier la topologie de surface du substrat, afin de créer une surface plane pour le substrat (après polissage).
- Par « autoriser une gravure chimique sélective », on entend que le deuxième matériau peut être gravé chimiquement sans attaquer la couche intercalaire. En pratique, un agent de gravure est choisi de sorte que la vitesse de gravure du deuxième matériau est au moins 5 fois supérieure (de préférence 10 fois supérieure) à la vitesse de gravure de la couche intercalaire.
- Par « affleurer le sommet des plots de contact électrique », on entend que la surface de la première couche d'aplanissement s'étendant entre deux plots de contact adjacents (i.e. en dehors de la hauteur de marche) et la surface supérieure des plots de contact électrique (i.e. le sommet) sont coplanaires. En d'autres termes, la surface de la première couche d'aplanissement s'étendant entre deux plots de contact adjacents se situe à la même position (suivant la normale à la surface du substrat) que celle de la surface supérieure des plots de contact électrique.

Autrement dit, la surface de la première couche d'aplanissement s'étendant entre deux plots de contact adjacents se situe à la même altitude (hauteur) que celle de la surface supérieure des plots de contact électrique.

- Par « polissage mécano-chimique » (CMP pour « *Chemical Mechanical Polishing»* en langue anglaise), on entend un procédé de polissage utilisant :

  (i) un tampon de polissage, mis en contact avec la surface libre (i.e. non recouverte) de l'empilement, le tampon de polissage et la surface libre de l'empilement étant classiquement mobiles en rotation autour d'axes de rotation parallèles (interaction mécanique) ;
  (ii) une solution de polissage, classiquement abrasive et corrosive, imprégnant le tampon de polissage (interaction chimique).

- Par « couche », on entend une unique couche ou une pluralité de sous-couches de même nature.

Ainsi, un tel procédé selon l'invention permet de limiter considérablement les conséquences de la non-uniformité d'un polissage mécano-chimique grâce à l'empilement formé lors de l'étape b), et plus précisément grâce à la couche intercalaire.

La couche intercalaire comporte une première partie faisant face aux plots de contact électrique suivant la normale au substrat, et une seconde partie s'étendant entre les plots de contact électrique, en dehors de la hauteur de marche formée par les puces électroniques surmontées par les plots de contact électrique. La seconde partie de la couche intercalaire agit comme une couche d'arrêt de polissage de la deuxième couche d'aplanissement, et son positionnement (juste au-dessus du plan formé par les plots de contact électrique) permet de réduire considérablement les phénomènes de sur-polissage au centre du substrat et dans les régions du substrat à faible densité de puces électroniques. La première partie de la couche intercalaire n'est pas utilisé comme une couche d'arrêt de polissage, et introduit simplement un retard dans le polissage des zones dites hautes (c'est-à-dire les zones où sont présents les plots de contact électrique).

Le procédé selon l'invention peut comporter une ou plusieurs des caractéristiques suivantes.

Selon une caractéristique de l'invention, le polissage mécano-chimique est exécuté lors de l'étape c) en utilisant une gravure chimique sélective entre le premier matériau et la couche de passivation.

Le premier matériau peut être gravé chimiquement sans attaquer la couche de passivation. En pratique, un agent de gravure est choisi de sorte que la vitesse de gravure du premier matériau est au moins 5 fois supérieure (de préférence au moins 10 fois supérieure) à la vitesse de gravure de la couche de passivation.

Selon une caractéristique de l'invention, le polissage mécano-chimique est exécuté lors de l'étape c) avec un unique agent de gravure chimique, sélectif :

- entre le deuxième matériau et le matériau de la couche intercalaire, et
- entre le premier matériau et la couche de passivation.

Ainsi, un avantage procuré est de pouvoir exécuter l'étape c) de manière continue, limitant ainsi le temps d'opération.

Selon une caractéristique de l'invention, la couche intercalaire de l'empilement formé lors de l'étape b) comporte une première partie faisant face aux plots de contact électrique suivant la normale au substrat ; et l'étape c) comporte les étapes successives :

$c_1$) polir la deuxième couche d'aplanissement, par un polissage mécano-chimique, jusqu'à atteindre la première partie de la couche intercalaire ;
$c_2$) graver la première partie de la couche intercalaire ;
$c_3$) polir la première couche d'aplanissement, par un polissage mécano-chimique, jusqu'à atteindre la couche de passivation revêtant les plots de contact électrique.

Autrement dit, un objet de l'invention est un procédé de reprise de contact électrique, comportant les étapes :

a) prévoir des puces électroniques, surmontées de plots de contact électrique, et formées sur un substrat ; les plots de contact électrique et le substrat étant revêtus d'une couche de passivation ;
b) former un empilement de couches d'aplanissement sur la couche de passivation, l'empilement comportant successivement :

- une première couche d'aplanissement, réalisée dans un premier matériau autorisant une gravure chimique sélective par rapport à la couche de passivation, et formée sur la couche de passivation de manière à affleurer les sommets des plots de contact électrique ;
- une couche intercalaire ;
- une deuxième couche d'aplanissement, réalisée dans un deuxième matériau ;

la couche intercalaire, intercalée entre les première et deuxième couches d'aplanissement, est réalisée dans un matériau autorisant une gravure chimique sélective du deuxième matériau par rapport à la couche intercalaire ; la couche intercalaire comportant une première partie faisant face aux plots de contact électrique suivant la normale au substrat ;
c) retirer l'empilement jusqu'à atteindre la couche de passivation (3) revêtant les plots (1) de contact électrique ; l'étape c) comportant les étapes successives :

$c_1$) polir la deuxième couche d'aplanissement, par un polissage mécano-chimique, jusqu'à atteindre la première partie de la couche intercalaire ;
$c_2$) graver la première partie de la couche intercalaire ;
$c_3$) polir la première couche d'aplanissement, par un polissage mécano-chimique, jusqu'à atteindre la couche de passivation revêtant les plots de contact électrique ;

d) graver la couche de passivation revêtant les plots de contact électrique de manière à mettre à nu les sommets des plots de contact électrique.

## Définition

Par « faisant face [...] suivant la normale au substrat », on entend que la première partie de la couche intercalaire est en regard des plots de contact, suivant la normale à la surface du substrat sur laquelle sont formées les puces électroniques.

Ainsi, un avantage procuré est de limiter le temps d'opération (réduire le retard de polissage des zones hautes) lorsque la sélectivité entre le deuxième matériau et le matériau de la couche intercalaire est très forte (par exemple un ratio entre la vitesse de gravure du deuxième matériau et la vitesse de gravure du matériau de la couche intercalaire supérieur à 20).

Selon une caractéristique de l'invention, le polissage mécano-chimique est exécuté lors de l'étape $c_1$) avec un premier agent de gravure chimique, sélectif entre le deuxième matériau et le matériau de la couche intercalaire ; le polissage mécano-chimique est exécuté lors de l'étape $c_3$) avec un deuxième agent de gravure chimique, sélectif entre le premier matériau et la couche de passivation, le deuxième agent de gravure chimique pouvant être identique au premier agent de gravure chimique.

On privilégiera un unique agent de gravure chimique afin de réduire le temps d'opération de l'étape c).

Selon une caractéristique de l'invention, la première couche d'aplanissement restant à l'issue de l'étape c) forme un masque de gravure autour des plots de contact électrique ; et l'étape d) est exécutée par une gravure chimique sélective.

Ainsi, un avantage procuré est de limiter le temps d'opération de l'étape d) ; le premier matériau s'étendant autour des plots de contact électrique forme un masque dur.

Selon une caractéristique de l'invention, l'étape b) est exécutée de sorte que les premier et deuxième matériaux sont identiques, et étant de préférence un oxyde de silicium.

Ainsi, un avantage procuré est de limiter le temps d'opération de l'étape b).

Selon une caractéristique de l'invention, l'étape b) est exécutée de sorte que le matériau de la couche intercalaire est un nitrure de silicium ou du carbone.

Ainsi, un avantage procuré par un nitrure de silicium (e.g. SiN, $Si_3N_4$) ou du carbone est d'autoriser une gravure sélective d'un oxyde de silicium (e.g. $SiO_2$).

Selon une caractéristique de l'invention, l'étape a) est exécutée de sorte que la couche de passivation est réalisée dans un nitrure de silicium.

Ainsi, un avantage procuré par ce matériau (dépourvu d'atomes d'oxygène) est de convenir tout particulièrement lorsque les puces électroniques sont des puces de mémoire résistive à accès aléatoire à base de lacunes d'oxygène.

Selon une caractéristique de l'invention, l'étape a) est exécutée de sorte que :

- chaque puce électronique, surmontée d'un plot de contact électrique, présente une épaisseur totale, notée $e_0$;
- la couche de passivation présente une épaisseur, notée $e_P$, inférieure ou égale à $e_0/2$.

### Définitions

- Par « épaisseur », on entend la dimension suivant la normale à la surface du substrat. Plus précisément, on entend la dimension de l'élément suivant la normale à la surface du substrat, en l'absence de rupture de planéité de l'élément en raison de la topologie de surface.
- Par « épaisseur totale », on entend l'épaisseur de l'ensemble comportant la puce électronique et son plot de contact électrique associé, prise à partir de la surface du substrat sur laquelle est formée la puce.

Selon une caractéristique de l'invention, l'étape b) est exécutée de sorte que la première couche d'aplanissement présente une épaisseur, notée $e_1$, vérifiant :

$$e_1 = e_0 - e_P.$$

Ainsi, un avantage procuré est de pouvoir former la première couche d'aplanissement de manière à affleurer le sommet des plots de contact électrique.

Selon une caractéristique de l'invention, l'étape b) est exécutée de sorte que la deuxième couche d'aplanissement présente une épaisseur, notée $e_2$, inférieure ou égale à $1,5\,e_0$.

Ainsi, un avantage procuré est de limiter le temps d'opération de l'étape c).

Selon une caractéristique de l'invention, la couche intercalaire formée lors de l'étape b) présente une épaisseur, notée $e_I$, qui est prédéterminée selon la sélectivité de la gravure chimique entre le deuxième matériau et le matériau de la couche intercalaire, ladite gravure chimique étant utilisée par le polissage mécano-chimique exécuté lors de l'étape c), $e_I$ étant de préférence comprise entre 5 nm et 15 nm.

### Définition

Par « prédéterminée selon la sélectivité », on entend que l'épaisseur de la couche intercalaire est choisie avant l'étape b) en fonction du ratio (connu) entre la vitesse de gravure du deuxième matériau et la vitesse de gravure du matériau de la couche intercalaire.

On choisira une épaisseur plus élevée (par exemple 15 nm) pour la couche intercalaire lorsque ledit ratio est faible (par exemple autour de 5), tandis qu'on choisira une épaisseur plus faible (par exemple 5 nm) pour la couche intercalaire lorsque ledit ratio est élevé (par exemple supérieur à 10).

Selon une caractéristique de l'invention, les puces électroniques prévues lors de l'étape a) sont des puces de mémoire résistive, de préférence de type à accès aléatoire à base de lacunes d'oxygène.

Selon une caractéristique de l'invention, les puces électroniques prévues lors de l'étape a) comportent chacune un empilement comprenant successivement : une première électrode, une couche active, et une seconde électrode ; la couche active étant de préférence un oxyde métallique. La seconde électrode forme le plot de contact électrique. Le plot de contact électrique assure le rôle de la seconde électrode. En d'autres termes, la seconde électrode et le plot de contact électrique sont confondus.

Selon une caractéristique de l'invention, l'étape a) est exécutée de sorte que :

- chaque puce électronique, surmontée d'un plot de contact électrique, présente une surface externe ;
- la couche de passivation est en contact direct avec toute la surface externe.

Ainsi, un avantage procuré par une telle couche de passivation est d'assurer une double fonction :

(i) une fonction d'arrêt de polissage de la première couche d'aplanissement lors de l'étape c) ;
(ii) une fonction de passivation ne nécessitant pas d'espaceurs (« *spacer* » en langue anglaise) dédiés additionnels pour les puces électroniques surmontées de plots de contact électrique, la fonction de passivation permettant notamment une isolation vis-à-vis d'une source d'oxygène qui serait préjudiciable pour des puces de mémoire résistive de type à accès aléatoire à base de lacunes d'oxygène.

Selon une caractéristique de l'invention, l'étape b) est exécutée de sorte que les premier et deuxième matériaux sont des oxydes de silicium.

## Brève description des dessins

D'autres caractéristiques et avantages apparaîtront dans l'exposé détaillé de différents modes de réalisation de l'invention, l'exposé étant assorti d'exemples et de références aux dessins joints.

[Fig. 1] Figure 1 est une vue schématique en coupe illustrant l'étape b) d'un procédé selon l'invention.

[Fig. 2] Figure 2 est une vue schématique en coupe illustrant l'issue de l'étape c) d'un procédé selon l'invention pour des régions du substrat à forte densité de puces électroniques.

[Fig. 3] Figure 3 est une vue schématique en coupe illustrant l'issue de l'étape c) d'un procédé selon l'invention pour des régions du substrat à faible densité de puces électroniques.

[Fig. 4] Figures 4a à 4f sont des vues schématiques en coupe illustrant des étapes d'un procédé selon l'invention.

[Fig. 5] Figure 5 est une vue schématique en coupe illustrant l'étape b) d'un procédé selon l'invention pour une puce électronique de type mémoire résistive.

[Fig. 6] Figures 6a à 6c sont des vues schématiques en coupe illustrant des étapes d'un procédé selon l'état de la technique.

[Fig.7] Figure 7 est une vue schématique en coupe illustrant une couche d'aplanissement surgravée à l'issue d'un procédé selon l'état de la technique.

[Fig. 8] Figure 8 est une vue schématique en coupe illustrant une couche d'aplanissement sous-gravée à l'issue d'un procédé selon l'état de la technique.

Il est à noter que les dessins décrits ci-avant sont schématiques, et ne sont pas à l'échelle par souci de lisibilité et pour en simplifier leur compréhension. Les coupes sont effectuées suivant la normale à la surface du substrat. Les traits pointillés illustrent l'affleurement de la première couche d'aplanissement avec le sommet des plots de contact électrique.

## Exposé détaillé des modes de réalisation

Les éléments identiques ou assurant la même fonction porteront les mêmes références pour les différents modes de réalisation, par souci de simplification.

Un objet de l'invention est un procédé de reprise de contact électrique, comportant les étapes :

a) prévoir des puces P électroniques, surmontées de plots 1 de contact électrique, et formées sur un substrat 2 ; les plots 1 de contact électrique et le substrat 2 étant revêtus d'une couche de passivation 3 ;

b) former un empilement de couches d'aplanissement 4, 5 sur la couche de passivation 3, l'empilement comportant :

- une première couche d'aplanissement 4, réalisée dans un premier matériau autorisant une gravure chimique sélective par rapport à la couche de passivation 3, et formée sur la couche de passivation 3 de manière à affleurer le sommet des plots 1 de contact électrique ;
- une deuxième couche d'aplanissement 5, réalisée dans un deuxième matériau ;
- une couche intercalaire CI, intercalée entre les première et deuxième couches d'aplanissement 4, 5, et réalisée dans un matériau autorisant une gravure chimique sélective du deuxième matériau ;

c) polir l'empilement, par un polissage mécano-chimique, jusqu'à atteindre la couche de passivation 3 revêtant les plots 1 de contact électrique ; le polissage mécano-chimique utilisant une gravure chimique sélective entre le deuxième matériau et le matériau de la couche intercalaire CI ;

d) graver la couche de passivation 3 revêtant les plots 1 de contact électrique de manière à mettre à nu le sommet des plots 1 de contact électrique.

Autrement dit, un objet de l'invention est un procédé de reprise de contact électrique, comportant les étapes :

a) prévoir des puces P électroniques, surmontées de plots 1 de contact électrique, et formées sur un substrat 2 ; les plots 1 de contact électrique et le substrat 2 étant revêtus d'une couche de passivation 3 ;

b) former un empilement de couches d'aplanissement 4, 5 sur la couche de passivation 3, l'empilement comportant successivement :

- une première couche d'aplanissement 4, réalisée dans un premier matériau autorisant une gravure chimique sélective par rapport à la couche de passivation 3, et formée sur la couche de passivation 3 de manière à affleurer les sommets des plots 1 de contact électrique ;
- une couche intercalaire CI ;
- une deuxième couche d'aplanissement 5, réalisée dans un deuxième matériau ;

la couche intercalaire CI, intercalée entre les première et deuxième couches d'aplanissement 4, 5, est réalisée dans un matériau autorisant une gravure chimique sélective du deuxième matériau par rapport à la couche intercalaire CI ;

c) polir l'empilement, par un polissage mécano-chimique, jusqu'à atteindre la couche de passivation 3 revêtant les plots 1 de contact électrique ; le polissage mécano-chimique utilisant une gravure chimique sélective entre le deuxième matériau et le matériau de la couche intercalaire CI ;

d) graver la couche de passivation 3 revêtant les plots 1 de contact électrique de manière à mettre à nu les sommets des plots 1 de contact électrique.

L'invention a également pour objet un procédé de reprise de contact électrique, comportant les étapes :

a) prévoir des puces P électroniques, surmontées de plots 1 de contact électrique, et formées sur un substrat 2 ; les plots 1 de contact électrique et le substrat 2 étant revêtus d'une couche de passivation 3 ;
b) former un empilement de couches d'aplanissement 4, 5 sur la couche de passivation 3, l'empilement comportant successivement :

- une première couche d'aplanissement 4, réalisée dans un premier matériau autorisant une gravure chimique sélective par rapport à la couche de passivation 3, et formée sur la couche de passivation 3 de manière à affleurer les sommets des plots 1 de contact électrique ;
- une couche intercalaire CI ;
- une deuxième couche d'aplanissement 5, réalisée dans un deuxième matériau ;

la couche intercalaire CI, intercalée entre les première et deuxième couches d'aplanissement 4, 5, est réalisée dans un matériau autorisant une gravure chimique sélective du deuxième matériau par rapport à la couche intercalaire CI; la couche intercalaire CI comportant une première partie 60 faisant face aux plots 1 de contact électrique suivant la normale au substrat 2 ;
c) retirer l'empilement jusqu'à atteindre la couche de passivation 3 revêtant les plots 1 de contact électrique ; l'étape c) comportant les étapes successives :

$c_1$) polir la deuxième couche d'aplanissement 5, par un polissage mécano-chimique, jusqu'à atteindre la première partie 60 de la couche intercalaire CI ;
$c_2$) graver la première partie 60 de la couche intercalaire CI ;
$c_3$) polir la première couche d'aplanissement 4, par un polissage mécano-chimique, jusqu'à atteindre la couche de passivation 3 revêtant les plots 1 de contact électrique ;

d) graver la couche de passivation 3 revêtant les plots 1 de contact électrique de manière à mettre à nu les sommets des plots 1 de contact électrique.

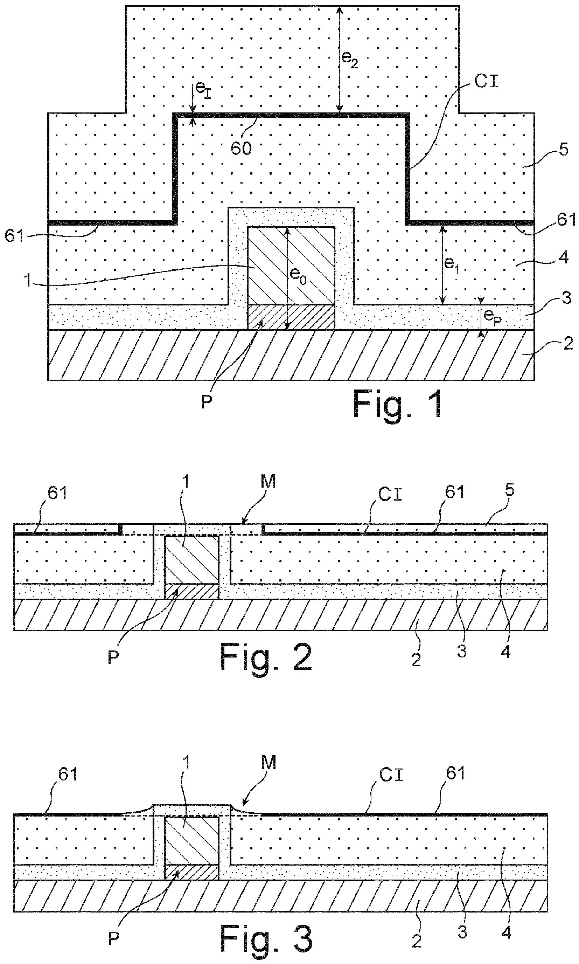

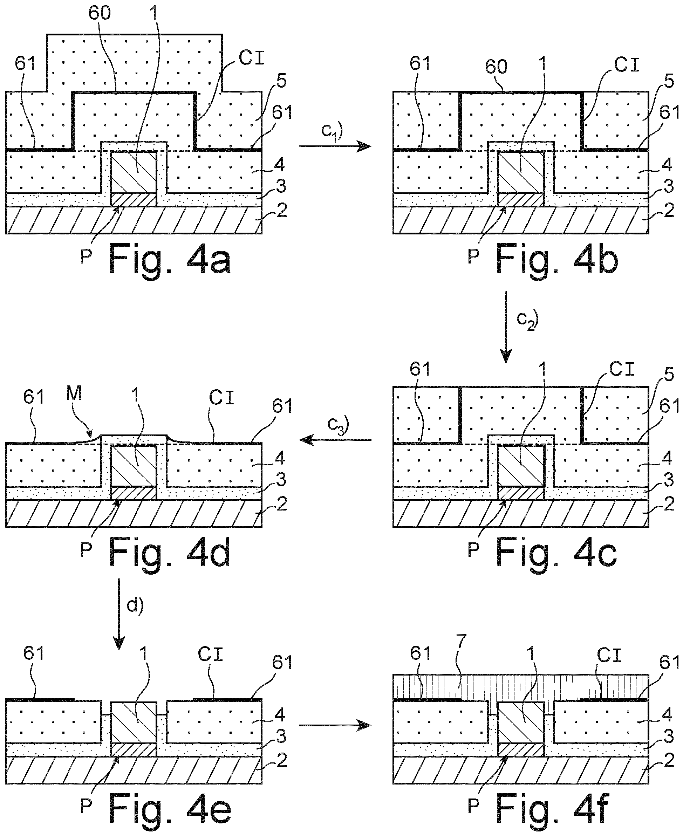

Le procédé est illustré à l'issue de l'étape b) aux figures 1, 4a et 5. Le procédé est illustré à l'issue de l'étape c) aux figures 2, 3 et 4d. Le procédé est illustré à l'issue de l'étape d) à la figure 4e.

**Substrat**

Le substrat 2 peut être une plaquette réalisée dans un matériau semi-conducteur, de préférence le silicium. Le substrat 2 peut être de type silicium sur isolant (SOI pour « *Silicon-On-Insulator*» en langue anglaise). Le substrat 2 peut intégrer de manière monolithique des composants (e.g. des transistors) qui ont été préalablement fabriqués par une unité de fabrication initiale (FEOL pour « *Front-End-Of-Line* » en langue anglaise).

**Puces électroniques**

L'étape a) est exécutée de sorte que chaque puce P électronique, surmontée d'un plot 1 de contact électrique, présente une épaisseur totale, notée $e_0$. L'épaisseur totale $e_0$ est prise à partir de la surface du substrat 2, et ne tient pas compte d'éventuels éléments enterrés. A titre d'exemple non limitatif, les plots 1 de contact électrique peuvent avoir une épaisseur comprise entre 120 nm et 150 nm, et chaque puce électronique P peut avoir une épaisseur comprise entre 3 nm et 10 nm, de sorte que $e_0$ peut être comprise entre 123 nm et 160 nm.

Les puces P électroniques prévues lors de l'étape a) peuvent être des puces de mémoire résistive, de préférence de type à accès aléatoire à base de lacunes d'oxygène, c'est-à-dire de type OxRAM pour « *Oxide-based Random-Access Memory*» en langue anglaise. D'autres architectures sont envisageables, telles que des puces de mémoire résistive de type :

- à pont conducteur (CBRAM pour « *Conductive Bridge Random-Access Memory* » en langue anglaise),
- à changement de phase (PCRAM pour « *Phase-Changed Random-Access Memory* » en langue anglaise).

Comme illustré à la figure 5, les puces P électroniques prévues lors de l'étape a) peuvent comporter chacune un empilement comprenant successivement : une première électrode BE, au moins une couche active CA, et une seconde électrode. La seconde électrode forme le plot 1 de contact électrique. Le plot 1 de contact électrique assure le rôle de la seconde électrode. En d'autres termes, la seconde électrode et le plot 1 de contact électrique sont confondus. Lorsque les puces P électroniques sont des puces de mémoire résistive de type OxRAM, la couche active CA est un oxyde métallique.

**Couche de passivation**

L'étape a) est avantageusement exécutée de sorte que la couche de passivation 3 est réalisée dans un nitrure de silicium. Le nitrure de silicium peut être $Si_3N_4$ ou ses dérivés nonstœchiométriques tels que SiN.
L'étape a) est avantageusement exécutée de sorte que la couche de passivation 3 présente une épaisseur, notée $e_P$, inférieure ou égale à $e_0/2$. L'étape a) est avantageusement exécutée de sorte que la couche de passivation 3 présente une épaisseur supérieure ou égale à 10 nm.

L'étape a) est avantageusement exécutée de sorte que :

- chaque puce P électronique, surmontée d'un plot 1 de contact électrique, présente une surface externe ;
- la couche de passivation 3 est en contact direct avec toute la surface externe.

La couche de passivation 3 peut agir comme une couche d'arrêt de polissage de la première couche d'aplanissement 4. En effet, la première couche d'aplanissement 4 est réalisée dans un premier matériau autorisant une gravure chimique sélective par rapport à la couche de passivation 3.

**Etape b) de formation de l'empilement de couches d'aplanissement**

L'étape b) est avantageusement exécutée de sorte que les premier et deuxième matériaux sont identiques. Les premier et deuxième matériaux sont de préférence un oxyde de silicium. L'oxyde de silicium est de préférence le dioxyde de silicium $SiO_2$ ou un dérivé non-stœchiométrique $SiO_x$.

L'étape b) est avantageusement exécutée de sorte que la première couche d'aplanissement 4 présente une épaisseur, notée $e_1$, vérifiant :

$$e_1 = e_0 - e_P.$$

L'égalité de l'équation ci-avant s'entend dans les tolérances usuelles liées aux conditions expérimentales de formation de la première couche d'aplanissement 4, et non parfaitement au sens mathématique du terme.

L'étape b) est avantageusement exécutée de sorte que la deuxième couche d'aplanissement 5 présente une épaisseur, notée $e_2$, inférieure ou égale à 1,5 $e_0$. L'étape b) est avantageusement exécutée de sorte que la deuxième couche d'aplanissement 5 présente une épaisseur, notée $e_2$, supérieure ou égale à 20 nm.

L'étape b) est exécutée par des techniques de dépôt permettant de suivre la topologie de surface de la couche de passivation 3, revêtant les plots 1 de contact électrique et le substrat 2, et par là-même de suivre la topologie de surface des plots 1 de contact électrique. Plus précisément, les techniques de dépôt sont adaptées pour présenter un taux de conformité (ratio entre l'épaisseur des flancs de la couche déposée et l'épaisseur en surface de la couche déposée) permettant de suivre la topologie de surface de la couche de passivation 3. A titre d'exemple, le taux de conformité des dépôts peut être compris entre 50% et 100%, préférentiellement compris entre 75% et 100%. Les première et deuxième couches d'aplanissement 4, 5 peuvent être déposées par un dépôt chimique en phase vapeur.

**Etape b) : couche intercalaire**

L'étape b) est avantageusement exécutée de sorte que le matériau de la couche intercalaire CI est un nitrure de silicium ou du carbone. Le nitrure de silicium peut être $Si_3N_4$ ou ses dérivés non-stœchiométriques tels que SiN.

La couche intercalaire CI de l'empilement formé lors de l'étape b) comporte une première partie 60 faisant face aux plots 1 de contact électrique suivant la normale au substrat 2. L'étape b) étant exécutée par des techniques de dépôt permettant de suivre la topologie de surface des plots 1 de contact électrique, la première partie 60 de la couche intercalaire fait face au sommet des plots 1 de contact électrique suivant la normale au substrat 2. La première partie 60 de la couche intercalaire CI forme le sommet de la couche intercalaire CI. La couche intercalaire CI de l'empilement formé lors de l'étape b) comporte une seconde partie 61 s'étendant entre les plots 1 de contact électrique, c'est-à-dire en dehors de la hauteur de marche formée par les puces électroniques P surmontées par les plots 1 de contact électrique. La seconde partie 61 de la couche intercalaire CI agit comme une couche d'arrêt de polissage de la deuxième couche d'aplanissement 5.

La couche intercalaire CI formée lors de l'étape b) présente une épaisseur, notée $e_I$, qui est avantageusement prédéterminée selon la sélectivité de la gravure chimique entre le deuxième matériau et le matériau de la couche intercalaire CI, ladite gravure chimique étant utilisée par le polissage mécano-chimique exécuté lors de l'étape c). L'épaisseur $e_I$ est de préférence comprise entre 5 nm et 15 nm.

La couche intercalaire CI peut être déposée sur la première couche d'aplanissement 4 par un dépôt chimique en phase vapeur.

**Etape c) de polissage**

Le polissage mécano-chimique est avantageusement exécuté lors de l'étape c) en utilisant une gravure chimique sélective entre le premier matériau et la couche de passivation 3. La couche de passivation 3 agit alors comme une couche d'arrêt de polissage de la première couche d'aplanissement 4.

Le polissage mécano-chimique est avantageusement exécuté lors de l'étape c) avec un unique agent de gravure chimique, sélectif :

- entre le deuxième matériau et le matériau de la couche intercalaire CI, et
- entre le premier matériau et la couche de passivation 3.

A titre d'exemple, on pourra utiliser comme agent de gravure une solution de polissage à base de $CeO_2$ (i.e. de type Ceria) lorsque les premier et deuxième matériaux sont un oxyde de silicium et lorsque le matériau de la couche intercalaire CI est un nitrure de silicium.

Selon un mode de mise en œuvre illustré aux figures 4a à 4d, l'étape c) comporte les étapes successives :

$c_1$) polir la deuxième couche d'aplanissement 5, par un polissage mécano-chimique, jusqu'à atteindre la première partie 60 de la couche intercalaire CI ;
$c_2$) graver la première partie 60 de la couche intercalaire CI ;
$c_3$) polir la première couche d'aplanissement 4, par un polissage mécano-chimique, jusqu'à atteindre la couche de passivation 3 revêtant les plots 1 de contact électrique.

Le polissage mécano-chimique est exécuté lors de l'étape $c_1$) avec un premier agent de gravure chimique, sélectif entre le deuxième matériau et le matériau de la couche intercalaire CI. Le polissage mécano-chimique est exécuté lors de l'étape $c_3$) avec un deuxième agent de gravure chimique, sélectif entre le premier matériau et la couche de passivation 3. Le deuxième agent de gravure chimique est avantageusement identique au premier agent de gravure chimique, par exemple lorsque les premier et deuxième matériaux sont identiques. L'étape $c_2$) consiste à graver la première partie 60 de la couche intercalaire CI, c'est-à-dire uniquement le sommet de la couche intercalaire CI. L'étape $c_2$) peut être exécutée par une gravure sélective ou non-sélective. A titre d'exemple, l'étape $c_2$) peut être exécutée par un plasma oxygène lorsque la couche intercalaire CI est réalisée en carbone.

Comme illustré à la figure 2, à l'issue de l'étape c), une portion résiduelle de la deuxième couche d'aplanissement 5 demeure sur la couche intercalaire CI pour des régions du substrat 2 à forte densité de puces P électroniques.

Comme illustré à la figure 3, à l'issue de l'étape c), la totalité de la deuxième couche d'aplanissement 5 est consommée sur la couche intercalaire CI pour des régions du substrat 2 à faible densité de puces P électroniques. La seconde partie 61 de la couche intercalaire CI a bien agi comme une couche d'arrêt de polissage de la deuxième couche d'aplanissement 5.

**Etape d) de gravure**

Comme illustré aux figures 2, 3 et 4d, la première couche d'aplanissement 4 restant à l'issue de l'étape c) forme un masque M de gravure autour des plots 1 de contact électrique ; et l'étape d) est avantageusement exécutée par une gravure chimique sélective. On pourra par exemple utiliser une chambre de gravure par plasma à couplage inductif (ICP « *Inductively Coupled Plasma* » en langue anglaise), le plasma pouvant être à base de $CH_2F_2$.

Comme illustré à la figure 4e, à l'issue de l'étape d), le sommet des plots 1 de contact électrique est mis à nu de sorte qu'une reprise de contact est possible, par exemple en déposant une couche de métallisation 7 (illustrée à la figure 4f) s'étendant sur les sommets des plots 1 de contact électrique mis à nu.

L'invention ne se limite pas aux modes de réalisation exposés. L'homme du métier est mis à même de considérer leurs combinaisons techniquement opérantes, et de leur substituer des équivalents.

**Revendications**

1. Procédé de reprise de contact électrique, comportant les étapes :

a) prévoir des puces (P) électroniques, surmontées de plots (1) de contact électrique, et formées sur un substrat (2) ; les plots (1) de contact électrique et le substrat (2) étant revêtus d'une couche de passivation (3) ;
b) former un empilement de couches d'aplanissement (4, 5) sur la couche de passivation (3), l'empilement comportant successivement :

- une première couche d'aplanissement (4), réalisée dans un premier matériau autorisant une gravure chimique sélective par rapport à la couche de passivation (3), et formée sur la couche de passivation (3) de manière à affleurer les sommets des plots (1) de contact électrique ;
- une couche intercalaire (CI) ;
- une deuxième couche d'aplanissement (5), réalisée dans un deuxième matériau ;

la couche intercalaire (CI), intercalée entre les première et deuxième couches d'aplanissement (4, 5), est réalisée dans un matériau autorisant une gravure chimique sélective du deuxième matériau par rapport à la couche intercalaire (CI) ;
c) polir l'empilement, par un polissage mécano-chimique, jusqu'à atteindre la couche de passivation (3) revêtant les plots (1) de contact électrique ; le polissage mécano-chimique utilisant une gravure chimique sélective entre le deuxième matériau et le matériau de la couche intercalaire (CI) ;
d) graver la couche de passivation (3) revêtant les plots (1) de contact électrique de manière à mettre à nu les sommets des plots (1) de contact électrique.

2. Procédé selon la revendication 1, dans lequel le polissage mécano-chimique est exécuté lors de l'étape c) en utilisant une gravure chimique sélective entre le premier matériau et la couche de passivation (3).

3. Procédé selon la revendication 2, dans lequel le polissage mécano-chimique est exécuté lors de l'étape c) avec un unique agent de gravure chimique, sélectif :

    - entre le deuxième matériau et le matériau de la couche intercalaire (CI), et
    - entre le premier matériau et la couche de passivation (3).

4. Procédé de reprise de contact électrique, comportant les étapes :

    a) prévoir des puces (P) électroniques, surmontées de plots (1) de contact électrique, et formées sur un substrat (2) ; les plots (1) de contact électrique et le substrat (2) étant revêtus d'une couche de passivation (3) ;
    b) former un empilement de couches d'aplanissement (4, 5) sur la couche de passivation (3), l'empilement comportant successivement :

        - une première couche d'aplanissement (4), réalisée dans un premier matériau autorisant une gravure chimique sélective par rapport à la couche de passivation (3), et formée sur la couche de passivation (3) de manière à affleurer les sommets des plots (1) de contact électrique ;
        - une couche intercalaire (CI) ;
        - une deuxième couche d'aplanissement (5), réalisée dans un deuxième matériau ;

    la couche intercalaire (CI), intercalée entre les première et deuxième couches d'aplanissement (4, 5), est réalisée dans un matériau autorisant une gravure chimique sélective du deuxième matériau par rapport à la couche intercalaire (CI) ; la couche intercalaire (CI) comportant une première partie (60) faisant face aux plots (1) de contact électrique suivant la normale au substrat (2) ;
    c) retirer l'empilement jusqu'à atteindre la couche de passivation (3) revêtant les plots (1) de contact électrique ; l'étape c) comportant les étapes successives :

        $c_1$) polir la deuxième couche d'aplanissement (5), par un polissage mécano-chimique, jusqu'à atteindre la première partie (60) de la couche intercalaire (CI) ;
        $c_2$) graver la première partie (60) de la couche intercalaire (CI) ;
        $c_3$) polir la première couche d'aplanissement (4), par un polissage mécano-chimique, jusqu'à atteindre la couche de passivation (3) revêtant les plots (1) de contact électrique ;

    d) graver la couche de passivation (3) revêtant les plots (1) de contact électrique de manière à mettre à nu les sommets des plots (1) de contact électrique.

5. Procédé selon la revendication 4, dans lequel le polissage mécano-chimique est exécuté lors de l'étape $c_1$) avec un premier agent de gravure chimique, sélectif entre le deuxième matériau et le matériau de la couche intercalaire (CI) ; le polissage mécano-chimique est exécuté lors de l'étape $c_3$) avec un deuxième agent de gravure chimique, sélectif entre le premier matériau et la couche de passivation (3), le deuxième agent de gravure chimique pouvant être identique au premier agent de gravure chimique.

6. Procédé selon l'une des revendications 1 à 5, dans lequel la première couche d'aplanissement (4) restant à l'issue de l'étape c) forme un masque (M) de gravure autour des plots (1) de contact électrique ; et l'étape d) est exécutée par une gravure chimique sélective.

7. Procédé selon l'une des revendications 1 à 6, dans lequel l'étape b) est exécutée de sorte que les premier et deuxième matériaux sont identiques, et étant de préférence un oxyde de silicium.

8. Procédé selon l'une des revendications 1 à 6, dans lequel l'étape b) est exécutée de sorte que le matériau de la couche intercalaire (CI) est un nitrure de silicium ou du carbone.

9. Procédé selon l'une des revendications 1 à 8, dans lequel l'étape a) est exécutée de sorte que la couche de passivation (3) est réalisée dans un nitrure de silicium.

10. Procédé selon l'une des revendications 1 à 9, dans lequel l'étape a) est exécutée de sorte que :

    - chaque puce (P) électronique, surmontée d'un plot (1) de contact électrique, présente une épaisseur totale, notée $e_0$; l'épaisseur totale étant l'épaisseur de l'ensemble comportant la puce électronique (P) et son plot (1) de contact électrique associé ;
    - la couche de passivation (3) présente une épaisseur, notée $e_P$, inférieure ou égale à $e_0/2$.

11. Procédé selon la revendication 10, dans lequel l'étape b) est exécutée de sorte que la première couche d'aplanissement (4) présente une épaisseur, notée

$e_1$, vérifiant :

$$e_1 = e_0 - e_P.$$

12. Procédé selon la revendication 10 ou 11, dans lequel l'étape b) est exécutée de sorte que la deuxième couche d'aplanissement (5) présente une épaisseur, notée $e_2$, inférieure ou égale à 1,5 $e_0$.

13. Procédé selon l'une des revendications 1 à 12, dans lequel la couche intercalaire (CI) formée lors de l'étape b) présente une épaisseur, notée $e_I$, qui est prédéterminée selon la sélectivité de la gravure chimique entre le deuxième matériau et le matériau de la couche intercalaire (CI), ladite gravure chimique étant utilisée par le polissage mécano-chimique exécuté lors de l'étape c), $e_I$ étant de préférence comprise entre 5 nm et 15 nm.

14. Procédé selon l'une des revendications 1 à 13, dans lequel les puces (P) électroniques prévues lors de l'étape a) sont des puces de mémoire résistive, de préférence de type à accès aléatoire à base de lacunes d'oxygène.

15. Procédé selon l'une des revendications 1 à 14, dans lequel les puces (P) électroniques prévues lors de l'étape a) comportent chacune un empilement comprenant successivement : une première électrode (BE), au moins une couche active (CA), et une seconde électrode ; la couche active (CA) étant de préférence un oxyde métallique, la seconde électrode formant le plot (1) de contact électrique.

16. Procédé selon l'une des revendications 1 à 15, dans lequel l'étape a) est exécutée de sorte que :

   - chaque puce (P) électronique, surmontée d'un plot (1) de contact électrique, présente une surface externe ;
   - la couche de passivation (3) est en contact direct avec toute la surface externe.

17. Procédé selon l'une des revendications 1 à 16, dans lequel l'étape b) est exécutée de sorte que les premier et deuxième matériaux sont des oxydes de silicium.

$e_2$

$e_I$

CI

60

5

61

$e_1$

1

$e_0$

61

4

3

$e_P$

2

P

# Fig. 1

61

1

M

CI

61

5

P

2

3

4

# Fig. 2

61

1

M

CI

61

P

2

3

4

# Fig. 3

Fig. 4a

Fig. 4b

Fig. 4c

Fig. 4d

Fig. 4e

Fig. 4f

CI

60

5

61

61

1

4

3

2

P    CA   CA   BE

# Fig. 5

1

4

3

2

P Fig. 6a

$c_0$)

1

4

3

2

P Fig. 6b

$d_0$)

1

4

3

2

P Fig. 6c

Fig. 7

Fig. 8

Europäisches
Patentamt

European
Patent Office

Office européen
des brevets

# RAPPORT DE RECHERCHE EUROPEENNE

**Numéro de la demande**

**EP 21 20 9321**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | US 2019/157099 A1 (CHEN SHENG-CHAU [TW] ET AL) 23 mai 2019 (2019-05-23) * alinéas [0015], [0016], [0022], [0024] – [0028]; figures 1, 3-7 * ----- | 1-17 | INV.<br>H01L21/56<br>H01L21/3105<br>H01L21/311<br>H01L21/321 |
| Y | US 2020/350365 A1 (CHEN SHENG-CHANG [TW] ET AL) 5 novembre 2020 (2020-11-05) * alinéas [0040] – [0043]; figures 5, 6A, 6B * ----- | 1-17 | H01L23/31<br>H01L21/768 |
| Y | US 2011/117677 A1 (YUAN JUN [US] ET AL) 19 mai 2011 (2011-05-19) | 16 | |
| A | * alinéa [0026]; figures 5c, 5d * ----- | 8,9 | |
| A | US 2018/197749 A1 (HUANG PO-CHENG [TW] ET AL) 12 juillet 2018 (2018-07-12) * le document en entier * ----- | 1-17 | |

**DOMAINES TECHNIQUES RECHERCHES (IPC)**

H01L

Le présent rapport a été établi pour toutes les revendications

| Lieu de la recherche | Date d'achèvement de la recherche | Examinateur |
|---|---|---|
| Munich | 4 janvier 2022 | Ronnås, Katharina |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...............................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 21 20 9321

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

04-01-2022

| Document brevet cité au rapport de recherche | Date de publication | Membre(s) de la famille de brevet(s) | Date de publication |
|---|---|---|---|
| US 2019157099 A1 | 23-05-2019 | CN 109585646 A | 05-04-2019 |
| | | DE 102018122524 A1 | 28-03-2019 |
| | | KR 20190037179 A | 05-04-2019 |
| | | TW 201916418 A | 16-04-2019 |
| | | US 10163651 B1 | 25-12-2018 |
| | | US 2019157099 A1 | 23-05-2019 |
| | | US 2020335353 A1 | 22-10-2020 |
| | | US 2021050220 A1 | 18-02-2021 |
| US 2020350365 A1 | 05-11-2020 | CN 111092066 A | 01-05-2020 |
| | | DE 102019114226 A1 | 23-04-2020 |
| | | KR 20200047299 A | 07-05-2020 |
| | | TW 202016933 A | 01-05-2020 |
| | | US 2020127047 A1 | 23-04-2020 |
| | | US 2020350365 A1 | 05-11-2020 |
| | | US 2020350366 A1 | 05-11-2020 |
| US 2011117677 A1 | 19-05-2011 | EP 1793433 A2 | 06-06-2007 |
| | | JP 5305584 B2 | 02-10-2013 |
| | | JP 2007158336 A | 21-06-2007 |
| | | US 2007120210 A1 | 31-05-2007 |
| | | US 2011117677 A1 | 19-05-2011 |
| US 2018197749 A1 | 12-07-2018 | CN 108281354 A | 13-07-2018 |
| | | US 2018197749 A1 | 12-07-2018 |

EPO FORM P0460

Pour tout renseignement concernant cette annexe : voir Journal Officiel de l'Office européen des brevets, No.12/82